# EUROPEAN PATENT APPLICATION

(11) **EP 1 130 138 A1**
(43) Date of publication of application: **05.09.2001**
(21) Application number: 99937038.0
(22) Date of filing: 11.08.1999
(51) Int. Cl.: C30B 29/58, C07H 21/00, C07K 1/14, C08H 1/00, C12N 9/00

(54) **CRYSTAL GROWING METHOD AND CRYSTAL GROWING APPARATUS**

(30) Priority: 12.08.1998 JP 22787998
(71) Applicant: SUMITOMO METAL INDUSTRIES, LTD., Osaka-shi, Osaka 541-0041 (JP)
(72) Inventor: SANJOH, Akira, Electronics Engineering Lab., Amagasaki-shi, Hyogo 660-0891 (JP)
(74) Representative: Stuart, Ian Alexander
(86) International application number: JP9904361
(87) International publication number: WO0009786

(57) **Abstract**

An apparatus for crystal growth includes: a solid-state element (22) having a region (22a) whose valence electrons are controlled so as to control the concentration of holes or electrons on a surface portion of the region in response to the environment of a solution (23) containing a macromolecular compound; and a heating element (24) provided in the vicinity of the region (22a). The region (22a) whose valence electrons are controlled is an impurity region formed on a silicon semiconductor substrate. The heating element (24) has an electrothermal line of Cr. In a crystal growth method, the solution (23) is heated by the heating element (24). Under an electric state generated on the surface of the region (22a), a crystal of the macromolecular compound is formed from the heated solution (23).

## Description

### Technical Field

The present invention relates to a method and an apparatus for growing a crystal of a chemical substance, and more particularly, it relates to improvements of a method and an apparatus for growing a crystal of an organic compound or the like with a solid-state component having a region in which valence electrons are controlled and which comprises an impurity-doped semiconductor or the like.

### Background Art

In a conventional process for crystallization of a biological macromolecule such as protein, a treatment for eliminating a solvent from an aqueous or non-aqueous solution containing the macromolecule is basically carried out, so that the resulting supersaturated state can reduce the solubility, leading to crystal growth. As typical methods thereof, a batch method, dialysis, and vapor-liquid interdiffusion are known. These methods are selected and used depending upon the type, quantity, property, and the like of the sample.

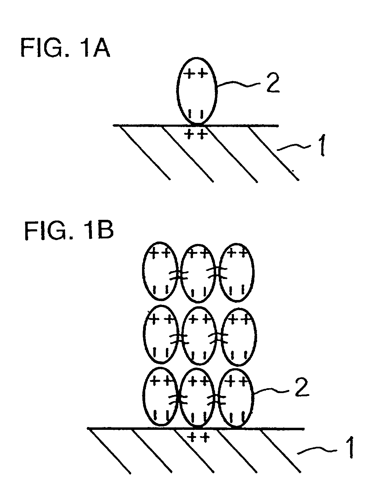

As a new method substituting for these methods, or as a method for more efficiently growing a crystal in combination with these methods, the inventor has developed a method and an apparatus for performing crystallization with a semiconductor substrate or the like whose valence electrons are controlled (refer to International Laying-Open Gazettes WO96/26781, WO97/49845 and WO98/02601). In this method, as shown in Fig. 1A, a crystal nucleus 2 is fixed by electrostatic action to the surface of a solid-state component 1 brought into a prescribed electric state by valence electron control. As shown in Fig. 1B, compounds such as protein aggregate on the solid-state component surface by electrostatic interaction, generation of crystal nuclei is promoted, and a crystal grows. Therefore, the crystallization can be controlled by controlling electric characteristics of the solid-state component surface. For example, the type, quantity, arrangement density or the like of the crystal nuclei fixed on the solid-state component surface can be adjusted by valence electron control, whereby the crystallization can be controlled.

In general, a biological macromolecule such as protein has an extremely large molecular weight and a small self-diffusion coefficient in a solution, so that aggregation or association of the molecules necessary for crystal nucleation hardly takes place. This is a factor in the difficulty of crystallization of a biological macromolecule such as protein.

### Disclosure of Invention

An object of the present invention is to improve the method and apparatus employing a solid-state component having a region where valence electrons are controlled for control of crystallization, and to provide a method and an apparatus which can produce crystallization more readily or more quickly.

Another object of the present invention is to improve the methods and the apparatuses disclosed in Internal Application Gazettes WO96/26781, WO97/49845 and WO98/02601 and to provide a method and an apparatus which can produce crystallization more readily or more quickly.

The present invention is directed to a method of growing a crystal of a macromolecular compound contained in a solution, which comprises the steps of: providing a solid-state component having a region whose valence electrons have been controlled so as to control the concentration of holes or electrons on a surface portion of the region in response to the environment of the solution containing the macromolecular compound; providing a heating element on the region of the solid-state component whose valence electrons have been controlled or in the vicinity of the region, holding the solution containing the macromolecular compound on the region whose valence electrons have been controlled; and heating the held solution with the heating element. By this method, a crystal of the macromolecular compound is formed from the heated solution under an electric state generated on the surface of the solid-state component by the controlled valence electrons.

In a preferred mode, the method according to the present invention comprises the steps of: providing a solid-state component in which the concentration of holes or electrons present at a surface thereof has been controlled or a solid-state component which has been modified to have regions of varying electric potentials on a surface thereof; providing a heating element on the surface of the solid-state component or in the vicinity thereof; holding a solution containing a macromolecular compound on the surface of the solid-state component; and heating the held solution with the heating element. By this method, a crystal of the macromolecular compound is formed from the heated solution under an electric potential generated on the surface of the solid-state component.

In another preferred mode, the method according to the present invention comprises the steps of: doping a surface of a solid-state component with a dopant to modify the concentration of holes or electrons present at the surface of the solid-state component; providing a heating element on the surface of the solid-state component or in the vicinity thereof; holding a solution containing a macromolecular compound on the surface of the solid-state component; and heating the held solution with the heating element. By this method, a crystal of the macromolecular compound is formed from the heated solution under an electric potential generated on the surface of the solid-state component.

The method according to the present invention may further comprise the step of measuring the heating temperature of the heating element. The region whose valence electrons have been controlled such as a region in which the concentration of holes or electrons has been controlled or a region whose surface potential has been controlled, may comprise a semiconductor to which an impurity is added.

The present invention is directed to an apparatus for crystal growth, which comprises: a solid-state component having a region whose valence electrons have been controlled so as to control the concentration of holes or electrons on a surface portion of the region in response to the environment of a solution containing a macromolecular compound; and a heating element separately prepared and then attached to the solid-state component. The heating element includes a base material prepared separately from the solid-state component and an electric heating material provided on the base material.

In a preferred mode, the apparatus according to the present invention comprises: a solid-state component in which the concentration of holes or electrons present at a surface thereof has been controlled or a solid-state component which has been modified to have regions of varying electric potentials on a surface thereof; and a heating element separately prepared and then attached to the solid-state component. The heating element includes a base material prepared separately from the solid-state component and an electric heating material provided on the base material.

In the apparatus according to the present invention, the heating element may include a resistance material provided on the base material for measuring the heating temperature of the electric heating material. The electric heating material may be in the form of a thin film. The resistance material may also be in the form of a thin film. The region whose valence electrons have been controlled, such as a region in which the concentration of holes or electrons has been controlled or a region whose surface potential has been controlled, may comprise a semiconductor to which an impurity is added.

Further, the present invention is directed to a heating element to be attached to a solid-state component for growing a crystal of a macromolecular compound contained in a solution. The heating element comprises: a substrate, which is different from a substrate forming the solid-state component and has a first surface to be brought into contact with the solid-state component and a second surface opposed to the first surface; and an electrothermal line provided on the second surface or on an insulating layer formed on the second surface.

The heating element according to the present invention preferably further comprises a resistance wire formed on the second surface or on the insulating layer formed on the second surface, in order to measure the heating temperature of the electrothermal line.

In the heating element according to the present invention, the electrothermal line and/or the resistance wire may be in the form of a thin film.

### Brief Description of Drawings

Fig. 1A and Fig. 1B are model diagrams showing such a situation that crystal nuclei are fixed to the surface of the solid-state component whose valence electrons are controlled and crystal growth proceeds.
Fig. 2 is a sectional view schematically showing an apparatus for crystal growth according to the present invention.
Fig. 3 is a model diagram showing such a situation that convection takes place and evaporation of solvent molecules occurs in a solution held on a solid-state component by heating with a heating element.
Fig. 4A is a diagram showing the relation between free energy and crystal nucleus sizes in crystal nucleation and crystal growth, and Fig. 4B is a model diagram showing such a situation that molecules aggregate and a crystal nucleus is formed.
Fig. 5 is a plan view showing a heating element employed for the present invention.
Fig. 6 is a perspective view showing a heating element having a thin film formed on a substrate.
Fig. 7 is a model diagram showing an arrangement in which an external power source and a resistance meter are respectively connected to the heating element as shown in Fig. 6.
Fig. 8 is a model diagram showing two heating elements serially connected on a solid-state component.
Fig. 9A is a plan view showing an apparatus for crystal growth having a plurality of heating elements according to the present invention, and Fig. 9B is an X-X sectional view of the apparatus shown in Fig. 9A.

Figs. 10A to 10C are plan views showing three types of heating elements employed for the apparatus for crystal growth shown in Figs. 9A and 9B.

Figs. 11A to 11F are sectional views schematically showing a fabrication process of the heating element employed for the present invention.

Referring to the drawings, 20 denotes an apparatus for crystal growth, 22 denotes a solid-state component, 22a denotes a controlled valence electron region, 23 denotes a solution, 24 54, 64, 64', 64a, 64b and 64c denote heating elements, 55a, 55b, 65a to 65d and 65'a to 65'b denote pads, 57, 67 and 67' denote electrothermal lines, and 68 and 68' denote resistance wires for temperature measurement respectively.

### Best Modes for Carrying Out the Invention

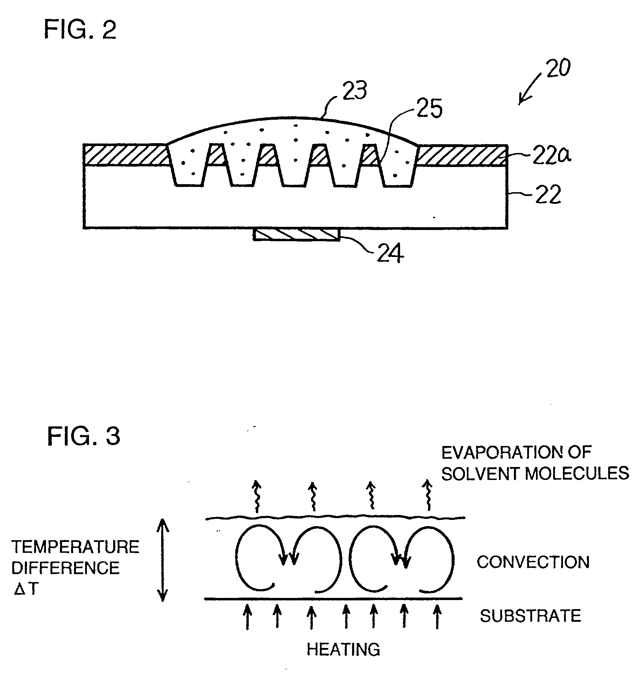

An apparatus according to the present invention may have the structure as shown in Fig. 2, for example. An apparatus 20 for crystal growth includes a solid-state component 22 and a heating element 24 prepared separately from the solid-state component 22 and provided on the solid-state component 22. The solid-state component 22 has a region (such as an impurity region formed on a semiconductor such as silicon) 22a where the valence electrons are controlled. The solid-state component 22 is formed to have grooves, holes, islands, projections or the like for the control of the crystallization as needed. In the apparatus shown in Fig. 2, a plurality of islands (projections) 25 are formed at a region of the surface of the solid-state component 22 where a solution 23 is held. The tops of the islands 25 and the vicinity thereof are the regions 22a where the valence electrons are controlled, and a substrate body forming the solid-state component is exposed at other portions (bottom portions of the islands and portions other than the islands). For example, the body of the solid-state component 22 may be an n-type silicon substrate, and the controlled valence electron region 22a may be a p-type silicon layer formed on the n-type silicon substrate. In this case, the tops of the islands 25 and the vicinity thereof are also of p-type silicon. Macromolecules such as protein to be crystallized electrostatically aggregate on the top of an island which is a region having valence electrons controlled, and are fixed to the top. A Crystal nucleus is then formed on the top of the islands 25. Thereafter crystallization proceeds around the crystal nucleus, and a crystal is formed on the islands. The heating element 24 is provided on a suitable portion of the solid-state component 22 to heat the solution 23 held for crystallization. In the apparatus 20, the heating element 24 is provided on the back side portion of the component 22 opposed to the region holding the solution 23. The heating element 24 heats the solution 23 for crystallization.

As shown in Fig. 3, the temperature of the solution rises by heating with the heating element, and temperature difference ΔT arises between the bottom and the surface of the solution. Further, solvent molecules evaporate from the surface of the solvent, and the concentration (density) of the solute rises in the surface part of the solution. Thus, the molecules move downward from the surface part of the solution and move upward from the bottom so that liquid flow (convection) occurs in the solution. Movement (migration) of the molecules to be crystallized is promoted by the heating energy. As the moving rate of the molecule increases, more molecules can aggregate from a distance to the region for crystallization to participate crystal nucleus formation. In addition, collision of the molecules in the solution readily takes place, so that crystal nucleus formation is promoted. The heating can also evaporate the solvent molecules to bring the molecules to be crystallized into a supersaturated state. The supersaturated solution allows a crystal to grow efficiently.

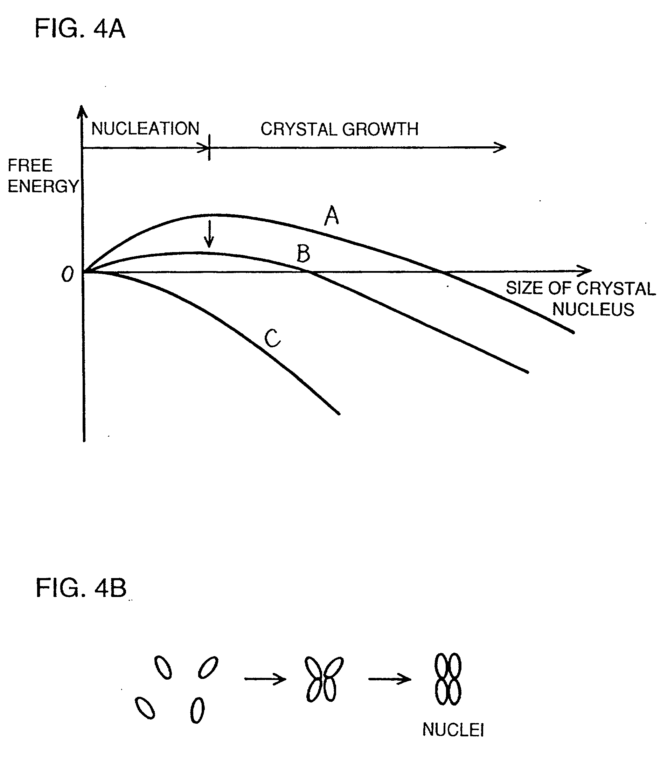

Fig. 4A schematically shows free energy change during a crystallization process. In the graph, the vertical axis represents free energy, and the horizontal axis represents the size of the crystal nucleus. Curve A shows the case of allowing the solution to stand in the crystallization process, curve B shows the case of heating by means of the heating element in the crystallization process according to the present invention, curve C shows a case where no crystal growth takes place (a case where an amorphous body or a mere molecular aggregate is formed). In general, the step of the crystal nucleus formation requires the largest energy. Once a crystal nucleus is formed, subsequent crystal growth progresses with smaller energy. As shown by the arrow from curve A to B, according to the present invention, the heating energy can promote the migration of the molecules and lower the energy barrier for nucleation. In other words, the activation energy for nucleation can be reduced. As shown in Fig. 4B, a crystal nucleus is formed when some molecules in a state separating from each other aggregate and are regularly arranged. Energy necessary for such a process is the activation energy.

The method of obtaining a supersaturated solution by heating is more reliable than a method employing a precipitant such as ammonium sulfate or NaCl. The precipitant can render protein an amorphous aggregate, and a long time can be required for obtaining a saturated solution.

In the present invention, the heating temperature may be set in the range of 30°C to 80°C, preferably 30°C to 50°C. A biological macromolecule such as protein can denature at a high temperature, and therefore it is desirable to avoid overheat. The heating temperature may be controlled by a temperature measurement means described later. In the crystal growth process according to the present invention, the heating is performed from the start of the crystallization process until a crystal nucleus is formed, and the heating may be stopped at the stage where the crystal nucleus is formed. After the solution is heated by the heating element to a temperature A in the range where the molecule such as protein do not denature so that the solvent such as water is evaporated, the heating temperature may be lowered from the temperature A to a temperature B at which a saturated solution is obtained. The temperature B may be set in the range of 30°C to 80°C, preferably 30°C to 50°C. The timing of stopping the heating may be managed by time. Specifically, the heating may be carried out for a prescribed time from the start of the crystallization process, and stopped when the prescribed time passes. In advance, crystal nucleus formation time may be measured for a test sample to set the time period of the heating. In such a test, the process of the crystallization can be observed with a microscope to measure the crystal nucleus formation time. The time period measured can be employed for the control of the heating program.

The present invention employs a solid-state component having a region whose valence electrons have been controlled so as to control the crystallization thereon. Such a solid-state component is disclosed in WO96/26781, WO97/49845 and WO98/02601. Typically, the region whose valence electrons have been controlled consists essentially of a semiconductor to which an impurity is added in a prescribed concentration. The semiconductor includes simple substance semiconductors such as Ge and Si and compound semiconductors such as Ga-As and CdS. The present invention may employ other materials as far as valence electrons can be controlled in such materials. Such available materials include ferroelectric substances such as barium titanate and strontium titanate as well as other inorganic or organic materials in which valence electron can be controlled.

The semiconductor material having valence electrons controlled may have a p-n junction part. A space charge layer may also be formed in the material having valence electrons controlled such that the crystallization can be controlled by a surface potential based on the space charge layer. The surface potential may vary over the surface portion of the solid-state component, so that the desired crystallization can be induced on a specific region of the surface. The surface potential or the electric state of the surface of the solid-state component can be controlled by the concentration of an impurity doped into the solid-state component. In the surface portion of the solid-state component, the concentration of the impurity may be reduced or increased continuously or stepwise from a first prescribed region to a second prescribed region. In the surface portion of the solid-state component, the impurity concentration can also be maximal or maximum or minimal or minimum at a specific region.

In the present invention, the solid-state component may have a plurality of grooves or holes. The plurality of the grooves or holes may have different depths and/or widths of the opening. In the solid-state component, the inside of the grooves or holes may differ from the out side thereof in the valence electrons controlled. For example, in the solid-state component employing a semiconductor substrate, the inside of the grooves or holes formed on the semiconductor substrate may differ from the out side thereof in the type and/or concentration of the impurity doped. Further, a water-repellent layer may be provided on the solid-state component to surround the plurality of grooves or holes formed thereon.

In the present invention, the solid-state component may have two opposed principal surfaces, at least two grooves or holes having different depths and/or widths of the openings formed on one surface of the two principal surfaces, and a through hole for supplying the solution containing the macromolecular compound to the grooves or holes from the side of the other surface of the two principal surfaces. In this solid-state component, valence electrons are controlled so that the crystallization of the macromolecular compound is promoted rather inside than outside the grooves or holes. Such a solid-state component may employ an impurity-added semiconductor substrate. The semiconductor substrate is formed to have a plurality of grooves or holes having different sizes, and the inside of the grooves or holes differs from the outside thereof in the type and/or concentration of the impurity.

The apparatus for crystal growth employed for the present invention may include: a plurality of the solid-state components having at least two grooves or holes with different depths and/or widths of the openings; and means for holding the plurality of the solid-state components opposed to each other with a prescribed clearance therebetween. In this apparatus, a solution containing molecules to be crystallized is held between the opposed solid-state components.

The apparatus employed for the present invention may have a plurality of solution storage parts for holding solutions necessary for crystal growth and a passage provided between the plurality of the solution storage parts. Such solution storage parts and a passage may be provided on the substrate having a region whose valence electrons have been controlled. At least one of the plurality of the solution storage parts has the region whose valence electrons have been controlled and crystallization is carried out in this region. For example, the apparatus for crystal growth may have a plurality of first solution storage parts for holding at least two types of solutions respectively, a plurality of second solution storage parts for keeping a solution containing a macromolecular compound to induce crystal growth, and a plurality of passages connecting the plurality of the first solution storage parts to the plurality of second solution storage parts for the circulation of the solutions. At least in the second solution storage part, valence electrons are controlled for the control of the crystallization. In particular, valence electrons are preferably controlled so that crystal nucleus formation and crystal growth are facilitated at a specific region of the second solution storage part while crystal nucleus formation is suppressed in the other region. In such a case, a crystal can be selectively grown at the specific region of the second solution storage part. The region where valence electrons are controlled may comprise a semiconductor to which an impurity is added. The second solution storage part may also be formed with a groove or hole.

In another mode, the apparatus for crystal growth employed for the present invention may comprise: a plurality of first solution storage parts for holding at least two types of solutions respectively; a plurality of first passages for discharging the solutions from the plurality of the first solution storage parts respectively and feeding the same in a direction; a second solution storage part simultaneously receiving at least two types of the solutions fed by the plurality of the first passages respectively; a second passage for discharging the solution from the second solution storage part and feeding the same in a direction; and a third solution storage part receiving the solution fed by the second passage. At least in the second solution storage part, valence electrons have been controlled for crystallization. The first passages and/or the second passage may be a groove formed on a substrate. These solution storage parts may also be formed on the substrate. The groove may have a stepwise shape or a gradient for feeding the solution in one direction. The first passages or the second passage may also be composed of a plurality of grooves having different widths and depths formed on the substrate. It is preferable that the width of each groove increases as going from the upstream to the downstream, and the depth of each groove increases as going from the upstream to the downstream. In this apparatus, the region where valence electrons are controlled may comprise a semiconductor to which an impurity is added. Also in this apparatus, valence electrons may be controlled so that crystal nucleus formation and crystal growth are facilitated at a specific region of the second solution storage part while crystal nucleus formation is suppressed in the other region.

In still another mode, the apparatus for crystal growth employed for the present invention comprises a substrate having a pair of opposed main surfaces and having a region whose valence electrons are controlled, wherein the substrate comprises: a first solution storage part, provided on one of the pair of the main surfaces, for holding a solution employed for crystal growth; a passage, provided on one of the pair of the main surfaces, for discharging the solution from the first solution storage part and feeding the same in a prescribed direction; a second solution storage part, provided on one of the pair of the main surfaces, for receiving the solution fed from the passage; a through hole for directing the solution present in the second solution storage part to the other one of the pair of the main surfaces; and a third solution storage part for receiving the solution fed through the through hole at the other one of the pair of the main surfaces. At least in the second solution storage part and/or the third solution storage part of the substrate, valence electrons have been controlled for crystallization. In this apparatus, the passage may be composed of a plurality of grooves having different widths and/or depths. The diameter of the through hole for feeding the solution from the second solution storage part to the third solution storage part may be varied with crystal growth conditions. The second solution storage part may be formed to have a groove or a hole. Valence electrons may be controlled so that crystal nucleus formation and crystal growth are facilitated at a specific region of the second solution storage part and/or the third solution storage part and crystal nucleus formation is suppressed in the other region. Typically, the region whose valence electrons are controlled comprises a semiconductor to which an impurity is added. Valence electrons can be modulated by the control of the concentration and/or the type of the impurity.

In the present invention, n-type and p-type silicon crystals are preferably employed as the material for the solid-state component. The characteristics of the silicon crystal employed may be equivalent to those of the silicon employed for a general LSI process. The specific resistance of the silicon crystal employed may be in the range of about 0.0001 to 1000 Ωcm, preferably in the range of 0.001 to 100 Ωm. Various methods may be used to obtain the silicon having valence electrons controlled into an n-type or a p-type. Ion implantation is one of such methods, which is simplest and can correctly modulate the impurity concentration. Valence electron control into p-type or n-type can readily be made by injecting ions of elements belonging to group III or group V of the periodic table into silicon and annealing the same. The group III elements for p-type include B, Al, Ga, In, Tl an the like. In particular, B is generally used. The group V elements for n-type include N, P, As, Sb and Bi. In particular, P, As or Sb is generally used. The surface of the silicon crystal is preferably mirror-polished. The thickness of the impurity layer formed at the surface of the silicon substrate is preferably 1 to 200 µm, more preferably 1 to 50 µm. A semiconductor crystal other than silicon may also be preferably employed for the present invention. Alternatively, materials other than the semiconductor crystal, such as an inorganic compound, an organic compound, a polymer compound or composites thereof, whose charge distribution is controlled or modified, may be a potential material for the present invention. The size of the opening and the depth of the groove or hole formed on the substrate may be set in any preferable range depending on the type of the molecule to be crystallized. Generally, the groove or hole has a width of the opening from 0.01 to 100 µm and the groove has a length from 1 to 10 mm. A plurality of the grooves or holes may be formed at intervals in the range of 1 µm to 1 mm. The depth of the groove or hole may be 0.01 to 200 µm. The thickness of the water-repellent layer formed to surround the solution storage part or the passages may be 0.1 to 100 µm. The water-repellent layer contributes to holding of the solution. The water-repellent layer may be made of water-repellent resin such as polyimide.

The region whose valence electrons are controlled for crystallization, the grooves, the holes, the islands, the solution storage parts, the passages for the solution and other structures provided as needed may be provided according to the disclosures of WO96/26781, WO97/49845 and WO98/02601. As to the structure of the solid-state component employed in the present invention and a method of fabricating the same, WO96/26781, WO97/49845 and WO98/02601 are incorporated herein by reference.

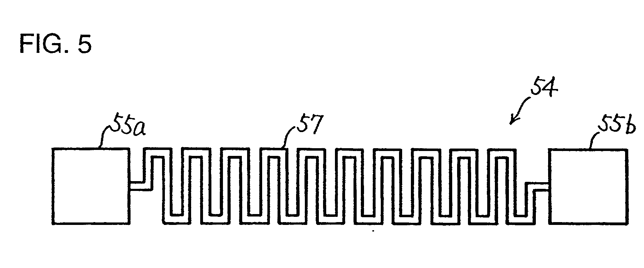

Fig. 5 shows an example of the heating element employed for the present invention. A heating element 54 has pads 55a and 55b to be connected to an external power source and an electrothermal line 57 connecting these pads. The electrothermal line 57 is folded in a compact shape between the pads 55a and 55b. The pads 55a and 55b is made of a good conductor such as aluminum or copper, and the electrothermal line 57 is made of an electric heating material such as Cr, an Fe-Cr-Al based alloy or an Ni-Cr based alloy. A current is fed through the electrothermal line 57 via the pads 55a and 55b to make the electrothermal line 57 produce heat. Different elements varying in the heating value per unit time can be obtained by changing the length, the width or the like of the electrothermal line 57.

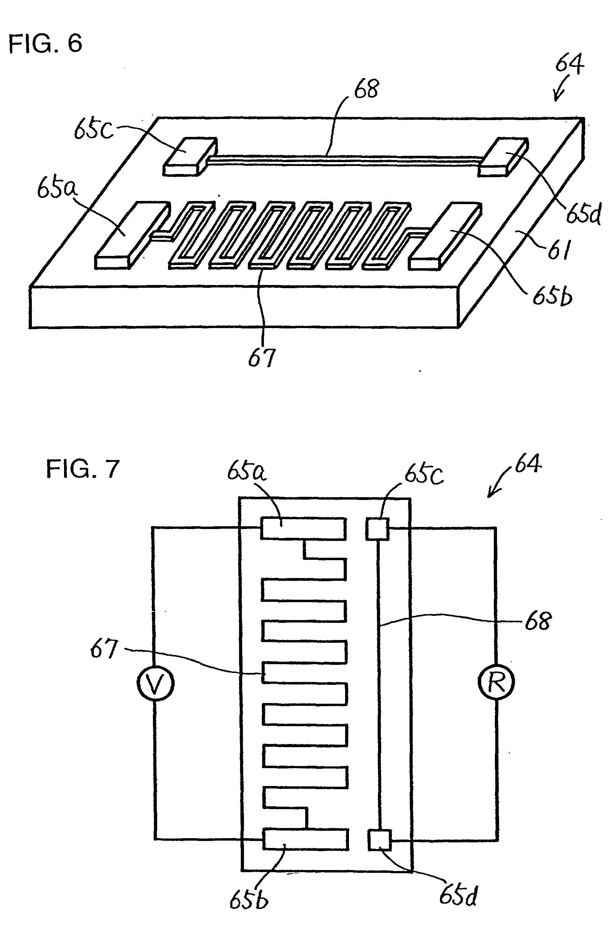

According to a preferred mode of the present invention, an electric heating material is provided on a base material. Fig. 6 shows an example of a preferable heating element. In a heating element 64, pads 65a and 65b are formed on a base material 61. An electrothermal line 67 is provided between the pads 65a and 65b. The pads 65a and 65b and the electrothermal line 67 are thin films formed on the base material 61. A silicon substrate or a glass substrate may be used for the base material 61. The pads 65a and 65b are thin films made of a good conductor such as aluminum or copper, and the electrothermal line 67 is a thin film made of an electric heating material such as Cr, an Fe-Cr-Al based alloy or an Ni-Cr based alloy. A resistance wire 68 for temperature measurement is provided adjacently to the electrothermal line 67. Pads 65c and 65d are provided at both ends of the resistance wire 68. The pads 65c and 65d are thin films made of a good conductor such as aluminum or copper, and the resistance wire 68 is a thin film made of a resistive material such as Cr, a copper-manganese alloy or a copper-nickel alloy. When the temperature has to be strictly controlled, the resistance wire for temperature measurement is preferably provided in the vicinity of the electrothermal line as shown in Fig. 6. For example, the thickness of the electrothermal line 67 is 0.1 µm to 1.0 µm, and the thickness of the pads 65a to 65d is 0.5 µm to 2.0 µm. The width of the electrothermal line 67 is 50 µm to 100 µm, for example. It is desirable to render the heat capacity of the resistance wire 68 as small as possible, in order to correctly measure the temperature of the heating element. Therefore, it is desirable to render the size of the resistance wire 68 as small as possible in a necessary range. For example, the width of the resistance wire 68 is preferably not more than 10 µm, and 1 to 10 µm, for example. The thickness of the resistance wire 68 is preferably not more than 0.3 µm, and 0.1 to 0.3 µm, for example.

The base material of the heating element preferably has excellent heat conductivity. For example, a metal, a semiconductor, ceramics or resin can be used for the base material of the heating element. When a conductive material such as a metal is used for the base material, an insulator film may be formed on its surface, and the electrothermal line may be formed on the insulator film. For example, an alumina film is formed on the surface of an aluminum plate and then the electrothermal line is formed thereon. In view of heat conductivity, the alumina film is arranged to have a suitable thickness. In view of simpler fabrication, a silicon substrate is an excellent material.

As shown in Fig. 7, the electrothermal line 67 is connected to an external power source for heat generation through the pads 65a and 65b, and the resistance wire 68 is connected to a resistance meter through the pads 65c and 65d. There is a correlation between the resistivity of the resistance wire 68 and the temperature. At room temperature or a temperature close thereto, for example, the resistivity of the resistance wire 68 is in proportion to the temperature. Therefore, the temperature of the heating element 64 can be obtained by measuring the resistivity of the resistance wire 68. The result of the temperature measurement is used for the control of the current value fed through the electrothermal line 67. Specifically, when the temperature is too high more than necessary, the current fed through the electrothermal line 67 is reduced to lower the temperature. When the measured temperature is low, the current fed through the electrothermal line 67 is increased. Thus, the heating temperature of the heating element is controlled.

In the present invention, the heating element or elements may be arranged on any desired position or positions in the solid-state component in any desired number or numbers. When the solid-state component has a plurality of the regions for crystallization, the heating elements in the corresponding numbers may be provided on the solid-state component. The heating element or elements may be placed on a suitable position or positions so as to effectively heat the solution held on the solid-state component and not come into contact with the solution. In addition, mass-produced heating elements may be used in any desired numbers to be arranged on any desired positions in the solid-state component. In view of a degree of flexibility in arrangement, the separately prepared heating element or elements used to be attached to the solid-state component are remarkably more advantageous than heating portions monolithically formed into the solid-state component itself.

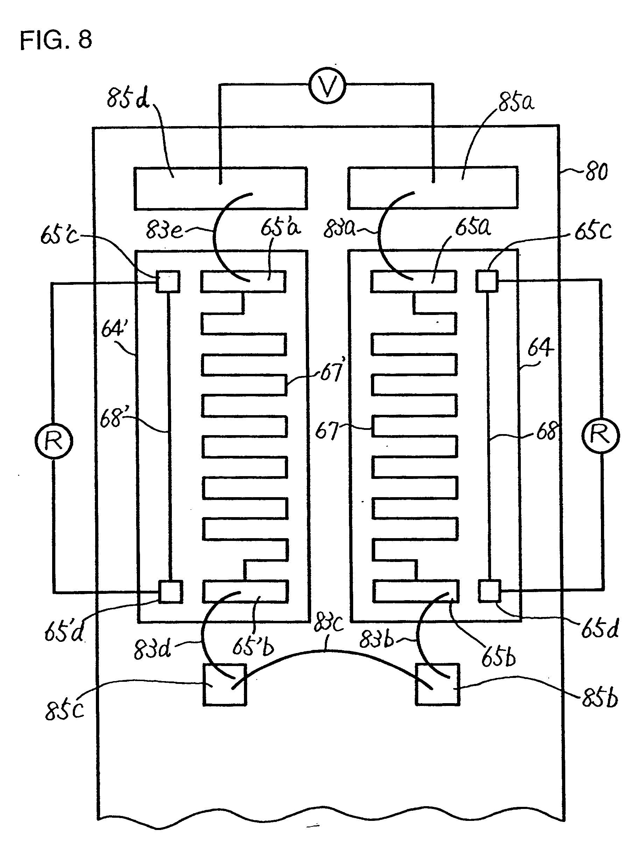

When a plurality of the heating elements are provided on a single solid-state component, the heating elements are serially connected so that power can be supplied to the heating elements from a single power source. Fig. 8 shows such a case. Two heating elements 64 and 64' are provided on a solid-state component 80. Pads 85a, 85b, 85c and 85d are also formed on the solid-state component 80. Pads 65a and 65b of the heating element 64 are respectively connected to the pads 85a and 85b through bonding wires 83a and 83b in the solid-state component 80. Similarly, pads 65'a and 65'b of the heating element 64' are connected to the pads 85d and 85c of the solid-state component by bonding wires 83e and 83d. The pads 85b and 85c are also connected by a bonding wire 83c. An external power source is connected to the pads 85a and 85d, and power is simultaneously supplied to electrothermal lines 67 and 67'. A resistance wire 68 is connected to a resistance meter through pads 65c and 65d, and a resistance wire 68' is connected to another resistance meter through pads 65'c and 65'd. The temperatures of the heating elements 64 and 64' can be measured independently.

When different heating elements varying in the length, width, thickness or the like of the electrothermal line are provided, different temperature conditions varying with the heating elements can be produced. In this case, crystallization can be induced under different temperature conditions. Preferably, in this case, the temperature of each heating element is independently measured. When a plurality of the same heating elements are arranged, each or one of the heating elements may be measured for the temperature. When a plurality of the heating elements provide substantially the same conditions, they should provide substantially the same temperature.

The heating element described above may be 1 to 10 mm, preferably 2 to 5 mm in length, 1 to 10 mm, preferably 2 to 5 mm in width, and 0.1 to 1 mm, preferably 0.2 to 0.5 mm in thickness. A heating element having a relatively small size is preferable since the same can have a large degree of flexibility in mounting. When the solid-state component for crystal growth (apparatus for crystal growth) has a small size, only one heating element of a relatively small size may be mounted. When the solid-state component has a large size, a plurality of the heating elements in any desired numbers may be mounted as needed. The heated region and the heating value can be controlled by changing the place and the number of the heating elements. The heating elements preferably have a suitable size in the aforementioned range, in view of fabrication and handling.

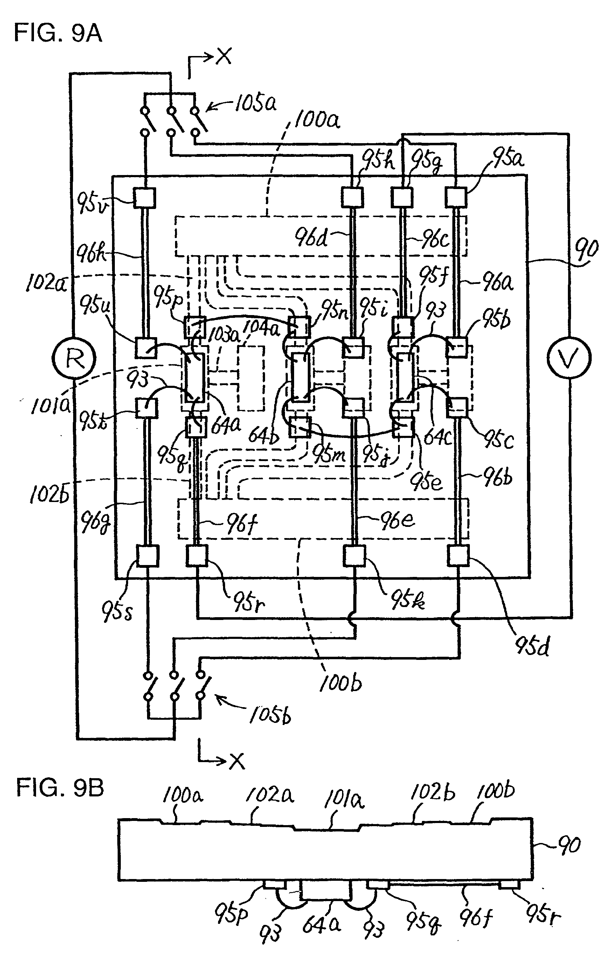

Figs. 9A and 9B show an apparatus for crystal growth having a plurality of reaction cells for crystallization and having a plurality of the heating elements adapted for the reaction cells. In the apparatus, the solid-state component has two solution cells, three reaction cells and three discharge cells. A reaction cell 101a is connected with a solution cell 100a through a passage 102a. The reaction cell 101a is also connected with a solution cell 100b through a passage 102b. The reaction cell 101a is further connected with a discharge cell 104a through a passage 103a. The other reaction cells are also similarly connected with the solution cells 100a and 100b and the discharge cells through passages. These cells and passages are formed on a silicon substrate. The passages are formed to feed a solution from the solution cells to the reaction cells and from the reaction cells to the discharge cells. The respective solution cells are obtained by forming V-shaped grooves around certain regions of a prescribed size by etching and partitioning the regions from the other region. In order to obtain the reaction cells, V-shaped grooves are formed around certain regions of a prescribed size by etching, and the regions of the prescribed size are further anisotropically etched at a prescribed depth. Further, certain regions of a prescribed size are anisotropically etched to obtain the discharge cells. In the solid-state component 90, a p-type silicon layer of low resistance (specific resistance: about 0.01 Ω·cm, thickness: about 5 µm) is formed on the surface of an n-type silicon substrate of about 30 Ω·cm in specific resistance by ion implantation of a phosphorus element and annealing. Further, a silicon oxide layer is formed on the surface in a thickness of 200 nm by thermal oxidation. In each reaction cell, a region of the thin p-type layer having a prescribed width is exposed by etching. Fig. 9A shows the arrangement of the respective cells and passages with dotted lines, and Fig. 9B shows the shape of the substrate surface formed with the respective cells and passages. Crystallization is performed in the reaction cells where the p-type silicon layer is exposed.

While the respective cells and passages are formed on the front side of the solid-state component 90, the back side has heating elements, and wiring layers and pads for supplying power the heating elements, together with pads and wiring layers for connecting a resistance meter to resistance wires for temperature measurement. Fig. 9A shows the arrangement of the heating elements, the pads and the wiring layers by solid lines. On the back side of the solid-state component 90, heating elements 64a, 64b and 64c are mounted on the positions corresponding to the respective reaction cells. Further, wiring layers 96a to 96h and pads 95a to 95k, 95m, 95n and 95p to 95v are formed on the back side of the solid-state component 90. These wiring layers and pads are formed by suitable lithography and vapor deposition of a metal such as aluminum or copper. Bonding wires 93 provide the connections between the pad and the heating element and between the pads. The three heating elements 64a to 64c are serially connected by the pads 95e to 95g, 95m, 95n and 95p to 95r, the wiring layers 96c and 96f and the bonding wires. An external power source may be connected to the pads 95g and 95r to supply the power simultaneously to the three heating elements. The pads for the resistance wires for temperature measurement of the respective heating elements are connected to the pads on the solid-state component 90 by the bonding wires 93. The resistance wires for temperature measurement provided on the respective heating elements are connected to the resistance meter through the pads 95a to 95d, 95h to 95k and 95s to 95v, the wiring layers 96a, 96b, 96d, 96e, 96g and 96h and the bonding wires of the solid-state component 90 and switches 105a and 105b. The temperatures of the respective heating elements can be measured with a single resistance meter by switching between the switches 105a and 105b.

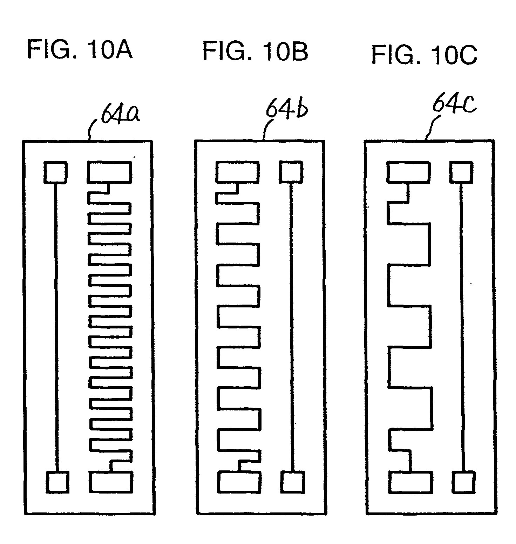

The three heating elements 64a, 64b and 64c provided on the apparatus as shown in Figs. 9A and 9B have structures as shown in Figs. 10A to 10C. The lengths of the electrothermal lines are different between the heating elements. The electrothermal line of the heating element 64a is longest and the electrothermal line of the heating element 64c is shortest, and therefore the heaving value per unit time is largest in the heating element 64a, while that of the heating element 64c is smallest. These heating elements supply different heating conditions to the reaction cells. Such heating elements having different heating performances may be arranged on the solid-state component and serially connected to provide different heating conditions by a single power source.

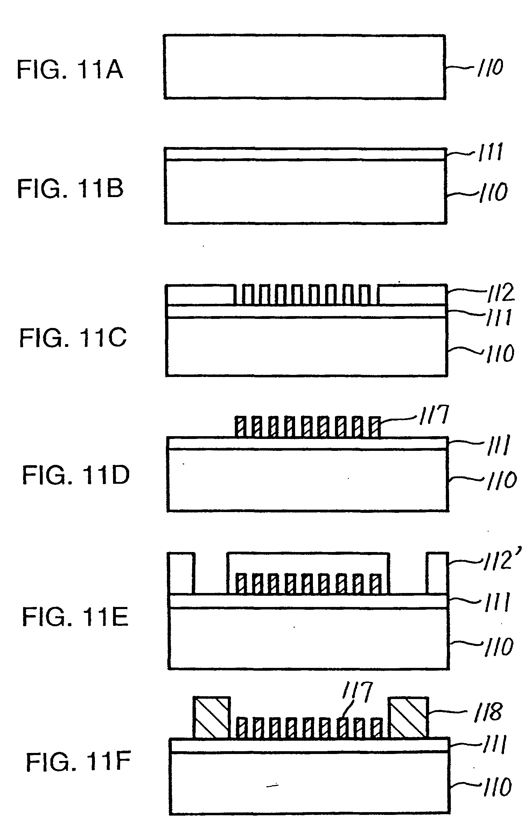

The heating element is obtained through a process as shown in Figs. 11A to 11F, for example. As shown in Fig. 11A, a substrate 110 of prescribed thickness and size is prepared. A silicon substrate is a preferable material in the point of workability. As shown in Fig. 11B, an electric insulating layer 111 is formed on the substrate 110 as needed. When a silicon substrate is used, a silicon oxide film is used for the electric insulating layer 111. After a resist material is applied onto the substrate 110, a resist pattern 112 is obtained by photolithography as shown in Fig. 11C. The resist pattern 112 has a pattern corresponding to the electrothermal lines and optionally a pattern corresponding to the resistance wires. After an electric heating material and optionally a resistive material are deposited on the substrate 110, the patterned resist is removed so that an electric heating layer 117 as shown in Fig. 11D and optionally a resistance layer (not shown) are obtained. For example, the electric heating material and the resistive material are deposited on the substrate 110 by physical vapor deposition such as sputtering. Then, after a thick resist material is applied onto the substrate, a resist pattern 112' shown in Fig. 11E is obtained by photolithography. The resist pattern 112' has a shape corresponding to the pads for the electric heating layer and optionally the pads for the resistance wires. A metal having high conductivity is deposited on the substrate 110 and the resist pattern is removed so that pads 118 as shown in Fig. 11F are obtained. The obtained heating element is mounted on the solid-state component, or bonded to the solid-state component with an adhesive. Preferably, it is bonded to the solid-state component with a conductive paste such as a silver paste excellent in heat conductivity.

The present invention can be used for crystallizing various macromolecular compounds, particularly macromolecular electrolytes. The present invention is preferably applied for crystallizing protein such as enzyme and membrane protein, polypeptide, peptide, polysaccharide, nucleic acid as well as composites and derivatives thereof. The present invention is preferably applied for crystallization of a biological macromolecule.

### Industrial Applicability

According to the present invention, heating by the heating element can promote crystal nucleus formation and accelerate crystal growth. According to the present invention, a biological macromolecule such as protein otherwise hard to be crystallized in a large size can be formed into a large-sized crystal that allows an X-ray structural analysis. The present invention is applied to study, development and preparation of useful substances, particularly biological macromolecules such as protein and nucleic acid in pharmaceutical industry, food industry and the like. Further, the present invention is applied to refining or crystallization of molecules of interest.

## Claims

1. A method of growing a crystal of a macromolecular compound contained in a solution, comprising the steps of:
providing a solid-state component having a region whose valence electrons have previously been controlled so as to control the concentration of holes or electrons on a surface portion of the region in response to the environment of the solution containing the macromolecular compound;
providing a heating element at the region of the solid-state component whose valence electrons have been controlled or in the vicinity of the region;
holding the solution containing the macromolecular compound on the region whose valence electrons have previously been controlled; and
heating the held solution by the heating element, whereby
a crystal of the macromolecular compound is formed from the heated solution under an electric state generated on the surface of the solid-state component by the previously controlled valence electrons.

2. The method according to claim 1, wherein the concentration of holes or electrons present at a surface of the solid-state component has previously been controlled, and the heating element is provided on the surface of the solid-state component or in the vicinity of the surface.

3. The method according to claim 1, wherein the solid-state component has previously been modified to have different regions of varying electric potentials on a surface thereof, and the heating element is provided on the surface of the solid-state component or in the vicinity of the surface.

4. The method according to any one of claims 1 to 3, further comprising the step of measuring the heating temperature of the heating element.

5. The method according to any one of claims 1 to 4, wherein the region whose valence electrons have previously been controlled or the surface of the solid-state component comprises a semiconductor to which an impurity is added.

6. A method of growing a crystal of a macromolecular compound contained in a solution, comprising the steps of:
doping a surface of a solid-state component with a dopant to modify the concentration of holes or electrons present at the surface of the solid-state component;
providing a heating element on the surface of the solid-state component or in the vicinity of the surface;
holding the solution containing the macromolecular compound on the surface of the solid-state component; and
heating the held solution by the heating element, whereby
a crystal of the macromolecular compound is formed from the heated solution under an electric potential generated on the surface of the solid-state component.

7. The method according to claim 6, further comprising the step of measuring the heating temperature of the heating element.

8. The method according to claim 6 or 7, wherein the surface of the solid-state component comprises a semiconductor to which an impurity is added.

9. An apparatus for growing a crystal of a macromolecular compound contained in a solution, comprising:
a solid-state component having a region whose valence electrons have previously been controlled so as to control the concentration of holes or electrons on a surface portion of the region in response to the environment of the solution containing the macromolecular compound; and
a heating element prepared separately from the solid-state component and attached to the solid-state component, wherein
the heating element comprises:
a base material prepared separately from the solid-state component, and
an electric heating material provided on the base material.

10. The apparatus according to claim 9, wherein the concentration of holes or electrons present at a surface of the solid-state component has previously been controlled.

11. The apparatus according to claim 9, wherein the solid-state component has previously been modified to have different regions of varying electric potentials on a surface thereof.

12. The apparatus according to any one of claims 9 to 11, wherein the heating element includes a resistive material provided on the base material for measuring the heating temperature of the electric heating material.

13. The apparatus for crystal growth according to any one of claims 9 to 12, wherein the electric heating material is in the form of a thin film.

14. The apparatus for crystal growth according to claim 12 or 13, wherein the resistive material is in the form of a thin film.

15. The apparatus according to any one of claims 9 to 14, wherein the region whose valence electrons have previously been controlled or the surface of the solid-state component comprises a semiconductor to which an impurity is added.

16. An apparatus for growing a crystal of a macromolecular compound contained in a solution, comprising:
a solid-state component which has a surface for growing the crystal of the macromolecular compound and is made of a silicon substrate cut into a desired shape;
a plurality of islands which are formed on a certain region of the surface of the solid-state component for growing the crystal of the macromolecular compound on the top of the islands or in the vicinity of the top; and
a heating element prepared separately from the solid-state component and attached to the solid-state component, wherein
the heating element comprises:
a substrate different from the solid-state component, and
an electrothermal line formed on the surface of the substrate or on an insulating layer formed on the surface of the substrate.

17. The apparatus according to claim 16, wherein the heating element further comprises a resistance wire formed on the surface of the substrate different from the solid-state component or an insulating layer formed on the surface of the substrate.

18. A heating element to be attached to a solid-state component for growing a crystal of a macromolecular compound contained in a solution, comprising:
a substrate which differs from a substrate forming the solid-state component and has a first surface to be brought into contact with the solid-state component and a second surface opposed to the first surface; and
an electrothermal line formed on the second surface or on an insulating layer formed on the second surface.

19. The heating element according to claim 18, further comprising a resistance wire formed on the second surface or on the insulating layer formed on the second surface for measuring the heating temperature of the electrothermal line.

20. The heating element according to claim 18 or 19, wherein the electrothermal line is in the form of a thin film.

21. The heating element according to claim 19 or 20, wherein the resistance wire is in the form of a tin film.
